# EUROPEAN PATENT APPLICATION

(11) **EP 3 511 097 A1**
(43) Date of publication of application: **17.07.2019**
(21) Application number: 17848673.4
(22) Date of filing: 01.09.2017
(51) Int. Cl.: B23B 27/14, B23B 27/20, B23B 51/00, B23C 5/16, B23D 77/00, B23F 21/00, B23G 5/06, C04B 35/5831, C04B 41/87, C22C 1/05, C23C 16/36

(54) **CUTTING TOOL AND METHOD FOR PRODUCING SAME**

(30) Priority: 06.09.2016 JP 2016173722
(71) Applicant: Sumitomo Electric Hardmetal Corp., Itami-shi, Hyogo 664-0016 (JP)
(72) Inventor: TSUKIHARA, Nozomi, Itami-shi Hyogo 664-0016 (JP); SETOYAMA, Makoto, Itami-shi Hyogo 664-0016 (JP); PASEUTH, Anongsack, Sorachi-gun Hokkaido 079-0304 (JP)
(74) Representative: Boult Wade Tennant LLP
(86) International application number: PCT/JP2017/031572
(87) International publication number: WO 2018/047733

(57) **Abstract**

A cutting tool includes a substrate and a coating film provided on the substrate, wherein the substrate is a cBN sintered material including more than or equal to 30 volume % and less than 80 volume % of cBN and a binder, the coating film includes a compound layer constituted of a composition of Ti₁₋ₓAlₓC₁₋ₐNₐ, where 0.70≤X≤0.95 and 0<a≤1, and the compound layer has a NaCl type crystal structure in a whole or part of the compound layer.

## Description

### TECHNICAL FIELD

The present invention relates to a cutting tool and a method for manufacturing the cutting tool. The present application claims a priority based on Japanese Patent Application No. 2016-173722 filed on September 6, 2016, the entire content of which is incorporated herein by reference.

### BACKGROUND ART

Conventionally, a cutting tool employing a cubic boron nitride sintered material (hereinafter, also referred to as "cBN sintered material") as a substrate has been known. The cBN sintered material is generally composed of cubic boron nitride (hereinafter, also referred to as "cBN") and a binder, and tends to have characteristics that greatly change depending on a content ratio of cBN.

Specifically, when the content ratio of cBN in the cBN sintered material is high, the cBN sintered material has high hardness but tends to have insufficient heat resistance. On the other hand, when the content ratio of cBN is low, the hardness is decreased as compared with that in the former case; however, the heat resistance can be improved. This is because cBN mainly contributes to the hardness of the cBN sintered material and the binder mainly contributes to the heat resistance of the cBN sintered material.

Hence, in the field of cutting processes, different types of cBN sintered materials are applied to cutting tools depending on a material of a workpiece, a required process precision, and the like. For example, in a process that requires heat resistance as in processing a hardened steel, a cBN sintered material (hereinafter, also referred to as "Low-cBN sintered material") having a comparatively low content ratio of cBN grains is used.

For example, Japanese Patent Laying-Open No. 2015-127093 (Patent Literature 1) discloses a cutting tool in which a coating film is provided on a surface of the Low-cBN sintered material. Patent Literature 1 describes that a finished surface roughness of a workpiece is improved by providing the coating film on the surface of the Low-cBN sintered material.

### CITATION LIST

### PATENT LITERATURE

PTL 1: Japanese Patent Laying-Open No. 2015-127093

### SUMMARY OF INVENTION

A cutting tool according to one embodiment of the present disclosure includes a substrate and a coating film provided on the substrate, wherein the substrate is a cBN sintered material including more than or equal to 30 volume % and less than 80 volume % of cBN and a binder, the coating film includes a compound layer constituted of a composition of Ti₁₋ₓAlₓC₁₋ₐNₐ, where 0.70≤X≤0.95 and 0<a≤1, and the compound layer has a NaCl type crystal structure in a whole or part of the compound layer.

A method for manufacturing a cutting tool according to one embodiment of the present disclosure includes: producing a substrate composed of a cBN sintered material including more than or equal to 30 volume % and less than 80 volume % of cBN and a binder; and forming a coating film on a surface of the substrate, wherein the forming of the coating film includes forming a compound layer by a CVD method, the compound layer being constituted of a composition of Ti₁₋ₓAlₓC₁₋ₐNₐ, where 0.70≤X≤0.95 and 0<a≤1, the compound layer having a NaCl type crystal structure in a whole or part of the compound layer.

### BRIEF DESCRIPTION OF DRAWINGS

Fig. 1 is a schematic cross sectional view showing an exemplary configuration of a cutting tool according to the present embodiment.
Fig. 2 is a schematic cross sectional view of a chemical vapor deposition apparatus used for production of a compound layer according to the present embodiment.

### DETAILED DESCRIPTION

### [Problem to be solved by the Present Disclosure]

In recent years, high-load cutting has been required in order to improve processing efficiency. Hence, in order to ensure stable high-load cutting, a cutting tool having a higher cutting characteristic is required. However, at present, there has not been provided yet a cutting tool that can be utilized stably in a cutting process that requires high heat resistance, such as high-load cutting of a hardened steel.

In view of the above, in the present disclosure, there are provided a cutting tool that ensures stable cutting even in high-load cutting, as well as a method for manufacturing the cutting tool.

### [Advantageous Effect of the Present Disclosure]

According to the description above, there can be provided a cutting tool that ensures stable cutting even in high-load cutting, as well as a method for manufacturing the cutting tool.

### [Description of Embodiments]

First, embodiments of the present invention are listed and described. It should be noted that in the present specification, the expression "A to B" represents a range of upper to lower limits (i.e., more than or equal to A and less than or equal to B). When no unit is indicated for A and a unit is indicated only for B, the unit of A is the same as the unit of B.
[1] A cutting tool according to one embodiment of the present invention includes a substrate and a coating film provided on the substrate. The substrate is a cBN sintered material including more than or equal to 30 volume % and less than 80 volume % of cBN and a binder. The coating film includes a compound layer constituted of a composition of Ti₁₋ₓAlₓC₁₋ₐNₐ, where 0.70≤X≤0.95 and 0<a≤1, and the compound layer has a NaCl type crystal structure in a whole or part of the compound layer.
   The above-described cutting tool can exhibit excellent wear resistance due to a synergistic effect of particularly high hardness and high heat resistance of the substrate and high strength and particularly high heat resistance of the coating film. Therefore, the above-described cutting tool ensures stable cutting even in high-load cutting.
[2] In the cutting tool, the binder includes at least one of Al and an Al compound, the Al compound being composed of Al and one or more elements selected from C, N, O, and B. Accordingly, adhesion between the substrate and the coating film is improved, whereby detachment resistance of the cutting tool is improved.
[3] In the cutting tool, the compound layer further has a wurtzite type crystal structure. Accordingly, lubricity of the coating film is improved.
[4] In the cutting tool, a ratio of the NaCl type crystal structure in the compound layer is more than or equal to 50 volume %. Accordingly, the compound layer can have high strength, whereby the wear resistance of the cutting tool is improved.
[5] A method for manufacturing a cutting tool according to one embodiment of the present invention includes: producing a substrate composed of a cBN sintered material including more than or equal to 30 volume % and less than 80 volume % of cBN and a binder; and forming a coating film on a surface of the substrate. The forming of the coating film includes forming a compound layer by a CVD method, the compound layer being constituted of a composition of Ti₁₋ₓAlₓC₁₋ₐNₐ, where 0.70≤X≤0.95 and 0<a≤1, the compound layer having a NaCl type crystal structure in a whole or part of the compound layer.

According to the above-described manufacturing method, it is possible to manufacture a cutting tool that ensures stable cutting even in high-load cutting.

### [Details of Embodiments of the Present Invention]

The following describes one embodiment (hereinafter, referred to as "the present embodiment") of the present invention. However, the present embodiment is not limited thereto. It should be noted that the same reference characters indicate the same or equivalent portions in figures used for description of the below-described embodiment. Moreover, when a compound or the like is expressed by a chemical formula in the present specification and an atomic ratio is not particularly limited, it is assumed that all the conventionally known atomic ratios are included. The atomic ratio is not necessarily limited to one in the stoichiometric range. For example, when "TiCN" is described, an atomic ratio in the TiCN is not limited to Ti:C:N=1:0.5:0.5, and include all the conventionally known atomic ratios.

### <Cutting Tool>

A cutting tool of the present embodiment includes a substrate and a coating film provided on the substrate. Although the coating film preferably coats the entire surface of the substrate, a configuration in which a portion of the substrate is not coated with this coating film or a configuration in which the configuration of the coating film partially differs does not deviate from the scope of the present invention.

The shape and application of the cutting tool according to the present embodiment are not particularly limited. Examples thereof can include a drill, an end mill, an indexable cutting insert for drill, an indexable cutting insert for end mill, an indexable cutting insert for milling, an indexable cutting insert for turning, a metal saw, a gear cutting tool, a reamer, a tap, an insert for crankshaft pin milling, and the like.

Moreover, the cutting tool according to the present embodiment is not limited to a tool, the whole of which has the above-described configuration, i.e., the whole of which includes the substrate and the coating film formed on the substrate. The cutting tool according to the present embodiment encompasses a cutting tool, only a portion (particularly, a cutting edge region (cutting edge portion) or the like) of which is constituted of the above-described configuration. For example, the cutting tool according to the present embodiment encompasses a cutting tool in which only a cutting edge region of a base body (supporting body) composed of cemented carbide or the like is constituted of the above-described configuration. In this case, regarding a manner of expression, the cutting edge region is regarded as a cutting tool. In other words, even when only a portion of a cutting tool is constituted of the above-described configuration, the above-described configuration will be referred to as a "cutting tool".

### <<Substrate>>

The substrate according to the present embodiment is a cBN sintered material including: more than or equal to 30 volume % and less than 80 volume % of cBN; and a binder. The substrate according to the present embodiment may include other component(s) as long as the above-described two components are included therein, and can include an inevitable impurity originating from an employed raw material, a manufacturing condition, or the like. Such a cBN sintered material is a Low-cBN sintered material having a comparatively low content ratio of cBN grains.

The content ratio (volume %) of cBN in the substrate can be achieved by setting the volume % of cBN powder, which is used to manufacture the cBN sintered material serving as the substrate, to fall within the above-described range. Moreover, the content ratio (volume %) of cBN in the substrate can be identified also by performing structure observation, elemental analysis, or the like onto the substrate using: quantitative analysis with inductively-coupled-plasma spectral analysis (ICP); an energy dispersive X-ray spectroscopy (EDX) apparatus included in a scanning electron microscope (SEM); or an EDX included in a transmission electron microscope (TEM).

For example, when the SEM is used, the content ratio (volume %) of cBN can be determined as follows. First, the cutting tool is cut at a certain position to produce a sample including a cross section of the substrate. For the production of the cross section of the substrate, a focused ion beam apparatus, a cross section polisher apparatus, or the like can be used. Next, the cross section of the cBN sintered material is observed with the SEM at a magnification of 2000 times to obtain a reflected electron image. In the reflected electron image, a region involving the cBN grains is represented by a black region, whereas a region involving the binder is represented by a gray region or a white region.

Next, a binarization process is performed onto the reflected electron image using image analysis software (for example, "WinROOF" provided by Mitani Corporation) to calculate each area ratio from the image having been through the binarization process. By assuming the calculated area ratio as volume %, the content ratio (volume %) of cBN can be determined. With this, the volume % of the binder can be also determined at the same time.

The substrate according to the present embodiment preferably has a surface roughness Rsub of 0.1 to 0.4 µm. When surface roughness Rsub of the substrate is more than or equal to 0.1 µm, adhesion between the substrate and the coating film is improved due to an anchor effect. On the other hand, when surface roughness Rsub of the substrate is more than 0.4 µm, a surface roughness reflected in the surface of the coating film is too large, with the result that it tends to be difficult to reduce the surface roughness of the surface of the coating film. When the surface roughness of the surface of the coating film is large, lubricity of the coating film is decreased. This is not preferable because the wear resistance of the cutting tool accordingly tends to be low.

Surface roughness Rsub can be determined as follows. First, the cutting tool is cut at a certain position to produce a sample including a cross section of the substrate. Next, a reflected electron image of the cross section, which is obtained by observing the cross section using a SEM at a magnification of 2000 times, is enlarged 2.5 times. Then, in a 50-µm square portion including an interface between the cBN sintered material and the coating film, this interface is traced by a thin line having a width of less than or equal to 0.3 mm.

The traced curve (wavelike line) is converted into numerical form using image analysis software, and a reference line (straight line) of the curve is set based on this. Next, the reference line is set as the X axis, a direction perpendicular thereto is set as the Y-axis, and values (magnitudes of distances from the X-axis) of Y are integrated in a range (50 µm) in the X direction. Then, a value calculated by dividing the integrated value by 50 µm is employed as surface roughness Rsub.

### (cBN)

cBN is present as cBN grains in the substrate. The average grain size (D₅₀) of the cBN grains is not particularly limited, and can be 0.1 to 10.0 µm, for example. Generally, as the average grain size is smaller, the hardness of the cBN sintered material tends to be higher. As variation in the grain size is smaller, the characteristics of the cBN sintered material tend to be more uniform.

D₅₀ of the cBN grains is determined as follows. First, in accordance with the above-described method for determining the content ratio of cBN, a sample including a cross section of the substrate is produced and a reflected electron image thereof is obtained. Next, image analysis software is used to calculate the equivalent circle diameter of each black region in the reflected electron image. By observing five or more visual fields, the equivalent circle diameters of 100 or more cBN grains are preferably calculated.

Next, the equivalent circle diameters are arranged in the order from the minimum value to the maximum value to determine a cumulative distribution. A grain size corresponding to a cumulative area of 50% in the cumulative distribution is D₅₀. It should be noted that the term "equivalent circle diameter" refers to the diameter of a circle having the same area as the area of a measured cBN grain.

### (Binder)

The binder preferably includes one or more compounds composed of at least one first element selected from a group consisting of a group 4 element (such as Ti, Zr or Hf), a group 5 element (such as V, Nb or Ta) and a group 6 element (such as Cr, Mo or W) in the periodic table, Al, and Si, and at least one second element selected from a group consisting of C, N, O and B. Specific examples of such compound(s) include AlCrN, AlN, TiN, CrN, Al₂O₃, AlB₂, Cr₂O₃, CrB₂, and the like. Since the binder including such compound(s) is excellent in adhesion with the coating film, detachment resistance of the cutting tool can be improved.

Particularly, the binder preferably includes at least one of Al and an Al compound, the Al compound being composed of Al and one or more elements selected from C, N, O, and B. In this case, the detachment resistance of the cutting tool can be improved further. Specific examples of the Al compound include AlCrN, AlN, Al₂O₃, and the like.

Moreover, the binder may include a compound composed of: at least one element of W and Co; and at least one element selected from a group consisting of N, B, and O. In this case, the cBN grains are combined more firmly to result in increased hardness of the substrate. Specific examples of such a compound include W₃Co₃C, W₃Co₂₁B₆, and the like.

The type and content ratio (mass %) of the compound included in the binder can be specified as follows. First, in accordance with the above-described method for determining the content ratio of cBN, a sample including a cross section of the cBN sintered material is produced. Next, an energy dispersive X-ray spectroscopy (EDX) apparatus included in a SEM or TEM is used to calculate the types and content ratios of the elements. Then, the type and content ratio of each compound are estimated using an X-ray diffractometer, and the content ratio of each compound is calculated based on these results.

### (Al₂O₃ Protective Film)

When the substrate according to the present embodiment includes Al and/or the Al compound as the binder, the substrate can have an Al₂O₃ protective film on a surface thereof. This Al₂O₃ protective film can be produced by performing laser processing onto the surface of the substrate including Al and/or the Al compound as the binder. The Al₂O₃ protective film may be formed on the entire surface of the substrate, but is formed on a portion of the surface of the substrate depending on the content of the binder.

The surface of the substrate having the Al₂O₃ protective film thereon is less likely to be oxidized than that of a substrate not having such a film. Hence, when the coating film is formed on the substrate having the Al₂O₃ protective film, unintended oxidation of the surface of the substrate is suppressed as compared with the substrate having no Al₂O₃ protective film. The unintended oxidation of the surface of the substrate tends to reduce the adhesion with the coating film. Therefore, in order to improve the adhesion with the coating film, the substrate preferably has the Al₂O₃ protective film. It should be noted that the Al₂O₃ protective film is regarded as a portion of the substrate.

### <<Coating Film>>

The coating film is provided on the substrate to coat the surface of the substrate. The coating film includes a compound layer constituted of a composition of Ti₁₋ₓAlₓC₁₋ₐNₐ (0.70≤X≤0.95 and 0<a≤1). The coating film may have a single-layer structure constituted of one layer or may have a stack structure in which two or more layers are stacked, as long as the coating film has the above-described compound layer.

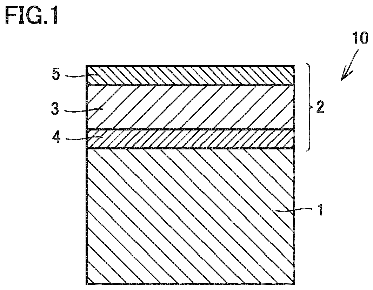

For example, as shown in Fig. 1, a coating film 2 provided on a substrate 1 may include not only a compound layer 3 but also an intermediate layer 4 provided between compound layer 3 and substrate 1, a surface layer 5 constituting the outermost surface of a cutting tool 10, and the like.

The coating film preferably has a thickness of 1.5 to 20 µm. When the thickness of the coating film is less than 1.5 µm, improvement of heat resistance, which relies on the coating film, may become insufficient. When the thickness of the coating film is more than 20 µm, the coating film may be detached due to a large pressure applied in high-load cutting.

The thickness of the coating film is determined as follows. First, a measurement sample is produced which includes a cross section parallel to a direction normal to the surface of the coating film of the cutting tool. Next, this cross section is observed with a scanning transmission electron microscope (STEM), and a magnification thereof is adjusted to include the whole of the coating film in the thickness direction in the observed image. Then, the thickness is measured at five or more points, and the average value thereof is regarded as the thickness. The same applies to the thickness of the compound layer described later.

The coating film according to the present embodiment preferably has a surface roughness Rasurf of 0 to 0.1 µm. When surface roughness Rasurf of the coating film is less than or equal to 0.1 µm, the surface of the coating film becomes particularly smooth. This leads to suppression of detachment of the coating film, chipping, or welding of a workpiece, each of which would have been otherwise caused from irregularities of the coating film, whereby the wear resistance of the cutting tool tends to be improved.

Surface roughness Rasurf is an arithmetic mean roughness defined in JIS B 0601-2001 when measuring a 400-µm square portion on the surface of the coating film using a stylus type surface shape measuring instrument. The surface of the coating film to be measured is preferably a rake face or flank face in the vicinity of the cutting edge of the cutting tool. This is because the surface shape of such a portion is greatly related with characteristics of the cutting tool.

### (Compound Layer)

The compound layer according to the present embodiment is constituted of the composition of Ti₁₋ₓAlₓC₁₋ₐNₐ (0.70≤X≤0.95 and 0<a≤1). This compound layer cannot be produced by a PVD method, and is produced by a CVD method.

The composition of the compound layer is identified as follows. First, a measurement sample is produced which includes a cross section parallel to the direction normal to the surface of the coating film of the cutting tool. Moreover, the cross section is ground as required to be smooth. Next, an energy dispersive X-ray spectroscopy (EDX) apparatus included in a scanning electron microscope (SEM) or TEM is used to analyze a certain region of the cross section.

Accordingly, a ratio of atoms in the certain region can be calculated. By performing the analysis repeatedly while shifting the region, atomic ratio x and atomic ratio a can be calculated in the entire cross section of the measurement sample. In this way, atomic ratio x and atomic ratio a in the certain cross section of the compound layer can be specified. Atomic ratio x and atomic ratio a thus specified are employed for the values in Ti₁₋ₓAlₓC₁₋ₐNₐ (0.70≤X≤0.95 and 0<a≤1).

It has been described above that the entire cross section is analyzed; however, the composition of the compound layer may be determined based on an analysis result of a portion of the cross section. However, it is preferable to analyze at least a square region having a length as large as 1/2 of the film thickness of the compound layer. This is due to the following reason: when the region to be analyzed is too small, it tends to be difficult to determine an average composition of the compound layer.

Moreover, the compound layer according to the present embodiment has a NaCl type crystal structure in a whole or part of the compound layer. When the compound layer having the above-described composition has the NaCl type crystal structure, both high strength and high heat resistance can be achieved. Moreover, since the coating film having such a compound layer is provided on the above-described substrate, a synergistic effect of respective characteristics of the substrate and the coating film is exhibited. Accordingly, the cutting tool according to the present embodiment can exhibit excellent wear resistance, thus ensuring stable cutting even in high-load cutting.

More than or equal to 50 volume % of the compound layer preferably has the NaCl type crystal structure. When less than 50 volume % of the compound layer has the NaCl type crystal structure, the strength of the compound layer may become insufficient. In order to improve the strength, more than or equal to 90 volume % of the compound layer more preferably has the NaCl type crystal structure, and 100 volume % of the compound layer further preferably has the NaCl type crystal structure.

Moreover, in addition to the above-described NaCl type crystal structure, the compound layer according to the present embodiment preferably has a wurtzite type crystal structure. In this case, the compound layer can be further excellent in lubricity. Since the improved lubricity of the compound layer leads to reduced frictional resistance of the cutting tool, the temperature of the cutting tool can be suppressed from being increased during processing, with the result that the wear resistance of the cutting tool can be improved. Particularly, in the case of the high-load cutting, a weld deposit originating from a workpiece tends to be welded to the cutting tool; however, the excellent lubricity of the compound layer leads to suppression of welding of the weld deposit.

The compound layer of the present embodiment can have both the NaCl type crystal structure and the wurtzite type crystal structure because the compound layer can have a plurality of compounds.

Examples of a compound that can have the NaCl type crystal structure in the compound layer include TiAlN, TiN, AlN, and the like. The compound layer preferably at least includes TiAlN having the NaCl type crystal structure. This is because the TiAlN having the NaCl type crystal structure is excellent in balance between the strength and the heat resistance.

Examples of a compound that can have the wurtzite type crystal structure in the compound layer include TiAlN, AlN, and the like. The compound layer preferably at least includes AlN having the wurtzite type crystal structure. This is because the AlN having the wurtzite type crystal structure is particularly excellent in lubricity.

The crystal structures of the compound layer, the compositions of the respective compounds having the crystal structures, and the ratio of each crystal structure can be identified using an X-ray diffractometer, an EDX apparatus included in a SEM or TEM, a SEM-EBSD apparatus, and the like.

For example, first, the cutting tool is cut at a certain position to produce a sample including a cross section of the coating film. Next, the EDX apparatus included in the SEM or TEM is used to specify the compound layer in the coating film. Next, the X-ray diffractometer and the SEM-EBSD apparatus are used to determine the crystal structures constituting the compound layer, the compositions of the respective compounds having the crystal structures, and the ratio of each crystal structure.

Moreover, the compound layer according to the present embodiment is a chemical vapor deposition layer produced by the CVD method. When chloride gas is used in the CVD method, Cl may be included in the compound layer. When the content ratio (atom %) of Cl is too high, the heat resistance of the compound layer tends to be decreased. Hence, the content ratio of Cl in the compound layer is preferably less than or equal to 9 atom %. It should be noted that the content ratio of Cl in the compound layer can be identified by, for example, the EDX apparatus included in the SEM or TEM; however, a detection limit value in this case is 0.05 atom %.

Moreover, the compound layer according to the present embodiment preferably has a thickness of 1.5 to 20 µm. When the thickness of the compound layer is less than 1.5 µm, improvement of the heat resistance, which relies on the compound layer, may become insufficient. When the thickness of the compound layer is more than 20 µm, self-destruction of the compound layer may take place due to a large pressure applied in high-load cutting.

### (Intermediate Layer)

The coating film according to the present embodiment preferably includes the intermediate layer between the compound layer and the substrate. Examples of the intermediate layer include: a physical vapor deposition layer produced by the PVD method; and a chemical vapor deposition layer produced by the CVD method.

Preferable examples of the physical vapor deposition layer includes: a Ti_{1-Y}Al_{Y}N layer (0≤Y≤0.95); an AlCrN layer; a TiN layer; and the like. Since such an intermediate layer is particularly excellent in adhesion with the substrate, the intermediate layer thus provided leads to more excellent adhesion between the coating film and the substrate. It should be noted that when 0.70≤Y, the Ti_{1-Y}Al_{Y}N layer (0≤Y≤0.95) does not have the NaCl type crystal structure, and is entirely constituted of the wurtzite type crystal structure.

Preferable examples of the chemical vapor deposition layer include: a Ti_{1-Z}Al_{Z}N layer (0≤Z<0.70); and a TiN layer. Since such an intermediate layer is particularly excellent in adhesion with the substrate, the intermediate layer thus provided leads to more excellent adhesion between the coating film and the substrate. It should be noted that the Ti_{1-Z}Al_{Z}N layer (0≤Z<0.70) may include any of the compound having the NaCl type crystal structure and the compound having the wurtzite type crystal structure.

It should be noted that atomic ratio Y and atomic ratio Z can be determined by the same method as the method for determining atomic ratio X. That is, as with atomic ratio X, each of atomic ratios Y and Z is the value of an average atomic ratio in each layer. Therefore, for example, atomic ratio Z may be increased/decreased continuously in the chemical vapor deposition layer as with the case where atomic ratio X may be increased/decreased continuously in the compound layer.

The intermediate layer is preferably provided directly on and in contact with the substrate in order to more increase a degree of improvement in the adhesion between the coating film and the substrate. For example, a physical vapor deposition layer (intermediate layer), a chemical vapor deposition layer (intermediate layer), and the above-described compound layer are more preferably provided on the substrate in this order. In this case, the adhesion between the coating film and the substrate can be particularly excellent.

### (Surface Layer)

The coating film according to the present embodiment preferably includes the surface layer at its outermost surface. The surface layer may be one of a physical vapor deposition layer and a chemical vapor deposition layer.

Specific examples of the surface layer include a TiB₂ layer, a TiN layer, and the like. These layers are preferable because they have colors. With this, a state of use of the cutting tool can be identified based on the color of the surface. It should be noted that the thickness of the surface layer is preferably less than or equal to 0.5 µm. When the surface layer has a thickness of more than or equal to 0.5 µm, the surface layer becomes less suitable as the layer indicating the state of use.

### <Method for Manufacturing Cutting Tool>

A method for manufacturing a cutting tool according to the present embodiment is a method for manufacturing the above-described cutting tool, the method including: a step (substrate producing step) of producing a substrate composed of a cBN sintered material including more than or equal to 30 volume % and less than 80 volume % of cBN and a binder; and a step (coating film forming step) of forming a coating film on a surface of the substrate, wherein the coating film forming step includes a step (compound layer forming step) of forming a compound layer by a CVD method, the compound layer being constituted of a composition of Ti₁₋ₓAlₓC₁₋ₐNₐ (0.70≤X≤0.95 and 0<a≤1), the compound layer having a NaCl type crystal structure in a whole or part of the compound layer. Hereinafter, each step will be described in detail.

### <<Substrate Producing Step>>

This step is a step of producing a substrate composed of a cBN sintered material including more than or equal to 30 volume % and less than 80 volume % of cBN and a binder. For example, a mixture, which includes cBN particles and raw material powder of the binder and is adjusted such that a mixing ratio of the cBN particles is more than or equal to 30 volume % and less than 80 volume %, is sintered at a high temperature and a high pressure. Accordingly, the above-described substrate is produced.

When the produced substrate constitutes the whole of the cutting tool, a subsequent step is performed onto this substrate. When the produced substrate constitutes a portion of the cutting tool, the substrate is joined to an appropriate portion of a base body of the cutting tool by a conventionally known wax material, and is then ground into a predetermined shape. Thereafter, this substrate (or the joined body including the substrate) is preferably subjected to the subsequent step.

Moreover, when the substrate includes Al and/or the Al compound as the binder, laser processing may be performed onto the surface of the substrate. Accordingly, the substrate having the above-described Al₂O₃ protective film can be obtained. Preferable conditions of the laser processing are as follows.

Laser output: 5 to 15 W
Frequency: 20 to 300 kHz.

### <<Coating Film Forming Step>>

This step is a step of forming a coating film on the surface of the substrate. This step includes a step (compound layer forming step) of forming a compound layer by a CVD method, the compound layer being constituted of a composition of Ti₁₋ₓAlₓC₁₋ₐNₐ (0.70≤X≤0.95 and 0<a≤1), the compound layer having a NaCl type crystal structure in a whole or part of the compound layer.

### (Compound Layer Forming Step)

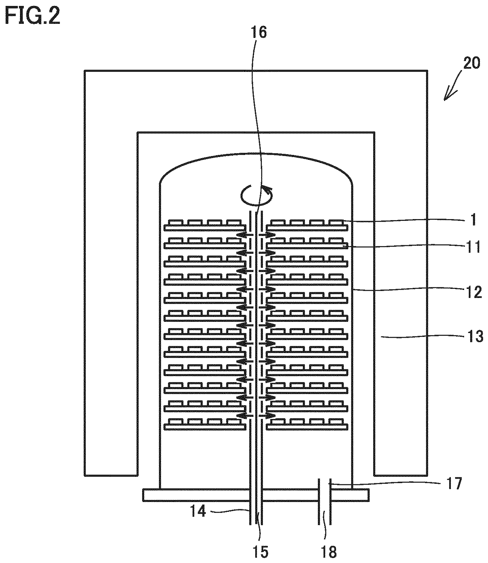

This step is a step of forming the above-described compound layer using the CVD method. In the CVD method of this step, a chemical vapor deposition apparatus shown in Fig. 2 can be used.

Fig. 2 is a schematic cross sectional view of the chemical vapor deposition apparatus (CVD apparatus) used for production of the compound layer according to the present embodiment. With reference to Fig. 2, a CVD apparatus 20 includes: a plurality of substrate holding jigs 11 for disposing substrates 1 thereon; and a reaction container 12 surrounding substrate holding jigs 11 and composed of a heat-resistant alloy steel. A temperature adjusting apparatus 13 for controlling a temperature in reaction container 12 is provided to surround reaction container 12.

In reaction container 12, a gas pipe having a gas inlet pipe 14 and a gas inlet pipe 15 adjacent to and joined to each other is provided to extend in a space inside reaction container 12 in a vertical direction and to be rotatable around its axis 16. The gas pipe is configured to avoid gas introduced into gas inlet pipe 14 and gas introduced into gas inlet pipe 15 from being mixed with each other in the gas pipe. Each of gas inlet pipe 14 and gas inlet pipe 15 is provided with a plurality of through holes for permitting the respective gases to flow from gas inlet pipe 14 and gas inlet pipe 15 onto substrates 1 disposed on substrate holding jigs 11.

Further, reaction container 12 is provided with a gas outlet pipe 17 for exhausting the gas from the inside of reaction container 12 to the outside of reaction container 12. The gas in reaction container 12 passes through gas outlet pipe 17, and is exhausted from a gas outlet 18 to the outside of reaction container 12.

The following describes a method for forming the compound layer using CVD apparatus 20. First, substrates 1 are disposed on substrate holding jigs 11 in reaction container 12. Next, the temperature of each substrate 1 is adjusted to 700 to 900°C using temperature adjusting apparatus 13, and the pressure in reaction container 12 is adjusted to 0.1 to 13 kPa.

Next, a first gas including Ti and Al is introduced into gas inlet pipe 14, and a second gas including C and/or N is introduced into gas inlet pipe 15. The gas pipe on this occasion is being rotated around its axis 16 as indicated by a rotational arrow in the figure. It should be noted that when a compound layer not including C is to be produced, a second gas not including C is used, whereas when a compound layer including both C and N is to be produced, a second gas including C and N is used.

Since the plurality of through holes are provided at the upper portions of gas inlet pipe 14 and gas inlet pipe 15, the first gas in gas inlet pipe 14 and the second gas in gas inlet pipe 15 are emitted into reaction container 12. Accordingly, the first gas and the second gas reach the surface of substrate 1 while being uniformly mixed within reaction container 12.

The first gas is preferably a mixed gas including a chloride gas such as TiCl₄ gas and AlCl₃ gas. This is because the chloride gas is suitable in the CVD method. Moreover, the first gas preferably further includes a carrier gas, such as N₂ gas, H₂ gas, Ar gas, and the like. When a compound layer not including C is to be produced, the second gas preferably includes a nitrogen-containing gas such as NH₃ and N₂, whereas when a compound layer including both C and N is to be produced, the second gas preferably includes not only the nitrogen-containing gas but also a hydrocarbon gas such as CH₄, C₂H₄, and the like. The hydrocarbon gas is preferably unsaturated hydrocarbon.

The composition of the compound layer can be controlled by adjusting: a mixing ratio of a Ti-containing gas (for example, TiCl₄ gas) and an Al-containing gas (for example, AlCl₃ gas in the first gas); and a flow rate ratio of the first gas and the second gas. Moreover, the thickness of the compound layer can be controlled by adjusting a time for introducing the first gas and the second gas in reaction container 12.

In the manner described above, the compound layer according to the present embodiment is formed. The compound layer thus produced by the CVD method can have a composition of Ti₁₋ₓAlₓC₁₋ₐNₐ (0.70≤X≤0.95 and 0<a≤1), and can have the NaCl type crystal structure in a whole or part of the compound layer.

It should be noted that in this step, the ratio of the wurtzite type crystal structure can be controlled by appropriately adjusting at least one of the flow rate (mol/min) of the Ti-containing gas in the first gas, a furnace pressure, and a furnace temperature. For example, the ratio of the wurtzite type crystal structure can be decreased by increasing the flow rate of the Ti-containing gas, the ratio of the wurtzite type crystal structure can be increased by increasing the furnace pressure, and the ratio of the wurtzite type crystal structure can be increased by increasing the furnace temperature.

### (Intermediate Layer Forming Step)

The coating film forming step according to the present embodiment may include an intermediate layer forming step before the above-described compound layer forming step. By including this step, the above-described intermediate layer can be provided between the substrate and the compound layer. As described above, examples of the intermediate layer include: a physical vapor deposition layer produced by the PVD method; and a chemical vapor deposition layer produced by the CVD method.

Examples of the PVD method include: a conventionally known AIP method (an ion plating method for evaporating a solid material using vacuum arc discharge); and a sputtering method. For example, in the AIP method, the intermediate layer can be formed using: a metal evaporation source including a metal to constitute the intermediate layer; and a reactive gas such as CH₄, N₂, or O₂. On the other hand, in the sputtering method, the intermediate layer can be formed using: a metal evaporation source including a metal to constitute the intermediate layer; a reactive gas such as CH₄, N₂, or O₂; and a sputtering gas such as Ar, Kr, or Xe.

As the CVD method, a conventionally known CVD method can be used. Moreover, when implementing the CVD method, CVD apparatus 20 described above may be used. In this case, the reactive gas is introduced into one of gas inlet pipe 14 and gas inlet pipe 15.

It should be noted that as conditions for forming the intermediate layer, conventionally known conditions can be employed. Moreover, when the intermediate layer has two or more layers, the layers may be formed sequentially.

### (Surface Layer Forming Step)

The coating film forming step according to the present embodiment may include a surface layer forming step after the above-described compound layer forming step. By including this step, the surface layer can be provided on the compound layer. A method for forming the surface layer is not particularly limited, and conventionally known PVD method and CVD method can be used.

Heretofore, the cutting tool according to the present embodiment and the method for manufacturing the cutting tool according to the present embodiment have been described. The above-described cutting tool is preferably used for processing of a hardened steel, particularly, high-load cutting of a hardened steel. This is because the cutting tool is excellent not only in hardness and heat resistance but also in oxidation resistance. That is, the cutting tool according to the present embodiment is preferably a cutting tool for high-load cutting of a hardened steel.

### Examples

### <Method for Measuring Each Value>

The content ratio of cBN in the substrate was determined in accordance with the above-described method using a SEM and image analysis software ("WinROOF" provided by Mitani Corporation). Moreover, the grain sizes of the cBN grains were measured in accordance with the above-described method using the image analysis software.

The binder included in the substrate was specified in accordance with the above-described method using an EDX ("X-Max80 Premium" provided by OXFORD INSTRUMENTS) included in the SEM and a X-ray diffractometer ("Smart-Lab" provided by RIGAKU).

The thickness of each layer included in the coating film was measured in accordance with the above-described method using the SEM. Moreover, the composition of each layer was specified using SEM-EBSD apparatuses ("SUPRA 35VP" provided by ZEISS and "OIM Analysis" provided by EDAX). Moreover, the SEM-EBSD apparatuses were also used to confirm that the compound layer had the NaCl crystal structure.

### <Production of Sample No. 1>

A cutting tool of a sample No. 1 was produced in the following manner. This cutting tool is a cutting tool according to an example of the present disclosure, and includes: the above-described substrate; and a compound layer (compound layer i) constituted of a composition of Ti₁₋ₓAlₓN (X=0.8).

### <<Production of cBN Sintered Material A>>

A substrate A having a feature shown in Table 1 was produced in the following manner. First, TiN powder (average particle size of 3 µm) and Al powder (average particle size of 4 µm) were mixed at a mass ratio of 95:5 to prepare a mixture. Next, the mixture was heated for 30 minutes at 1250°C in vacuum. The mixture having been through the heating was pulverized using a cemented carbide ball with φ 4 mm and a cemented carbide pot, thereby obtaining raw material powder of the binder. Next, cBN powder constituted of cBN particles (average particle size of 3 µm) was prepared, and was mixed with the raw material powder of the binder such that a mixing ratio (volume %) of the raw material powder of the binder and the cBN powder became 40:60, thereby preparing a powder mixture.

This powder mixture was placed in a vacuum furnace, and was degassed by increasing the temperature to 950°C and then holding it for 30 minutes. Then, the degassed powder mixture was layered on a cemented carbide supporting plate, which was then introduced into a capsule composed of Mo. This capsule was placed in an ultra-high pressure apparatus and was sintered for 20 minutes at a pressure of 5 GPa and a temperature of 1300°C. In this way, substrate A was produced.

### <<Production of Joined Body>>

A base body was prepared which had a shape defined as DNGA150408 in the ISO standard and was composed of a cemented carbide material (corresponding to K10). The above-described substrate A (with a triangular prism shape that had a thickness of 2 mm and that had a bottom surface in the form of an isosceles triangle having a vertex angle of 55° and having 2-mm sides sandwiching the vertex angle) was joined to a cutting edge (corner portion) of the base body. It should be noted that a wax material composed of Ti-Zr-Cu was used for the joining. Next, the outer peripheral surface, upper surface, and lower surface of the joined body were ground to form a negative land shape (with a negative land width of 150 µm and a negative land angle of 25°) at the cutting edge. In this way, the joined body was produced in which the cutting edge portion was constituted of substrate A.

### <<Production of Coating Film a>>

On the surface of the produced joined body, a coating film a shown in Table 2 was formed. In Table 2, for example, the notation "TiN (1.5)" means a TiN layer having a thickness of 1.5 µm. Each layer was produced under conditions shown in Table 3 and Table 4 using the CVD apparatus shown in Fig. 2. However, when producing the intermediate layer and the surface layer, the reactive gas was introduced into one gas inlet pipe rather than the two gas inlet pipes. The same applies to a coating film b and a coating film c described below.

In Table 3, for example, the notation "TiCl₄ (0.025)" in the column of the first gas means that the flow rate of TiCl₄ gas is 0.025 mol/min. Moreover, in Table 4, for example, the notation "TiCl₄ (2.0)" in the column of the reactive gas means that the ratio of the TiCl₄ gas in the reactive gas is 2.0 volume %.

**[Table 1]**

| | Content Ratio of cBN (vol%) | Grain Size of cBN Grains (µm) | Binder |
|---|---|---|---|
| Substrate A | 60 | 3 | AlN, TiN |

**[Table 2]**

| | Intermediate Layer | Compound Layer i | Compound Layer ii | Surface Layer |
|---|---|---|---|---|
| Coating Film a | TiN (1.5) | Ti_{0.2}Al_{0.8}N (6) | - | TiN (0.5) |
| Coating Film b | TiN (1.5) | - | Ti_{0.6}Al_{0.4}C_{0.1}N_{0.9} (6) | TiN (0.5) |
| Coating Film c | TiN (1.5) | - | - | TiN (0.5) |

**[Table 3]**

| | | Formation Method | First Gas (mol/min) | Second Gas (mol/min) | Pressure (kPa) | Temperature (°C) |
|---|---|---|---|---|---|---|
| Coating Film a | Compound Layer i | CVD Method | AlCl₃ (0.065) | N₂ (0.09) | 1.3 | 800 |
| | | | TiCl₄ (0.025) | H₂ (0.9) | | |
| | | | N₂ (1.0) | | | |
| | | | H₂ (2.9) | | | |
| Coating Film b | Compound Layer ii | CVD Method | AlCl₃ (0.028) | C₂H₄ (0.009) | 1.3 | 800 |
| | | | TiCl₄ (0.062) | N₂ (0.09) | | |
| | | | N₂ (2.9) | H₂ (0.9) | | |
| | | | H₂ (1.0) | | | |

**[Table 4]**

| | | Formation Method | Reactive Gas (volume %) | Pressure (kPa) | Temperature (°C) | Total Gas Volume (L/min) |
|---|---|---|---|---|---|---|
| Coating Film a | Intermediate Layer | CVD Method | TiCl₄ (2.0) | 6.7 | 915 | 63.8 |
| | | | N₂ (39.7) | | | |
| | | | H₂ (Remainder) | | | |
| | Surface Layer | CVD Method | TiCl₄ (0.5) | 79.8 | 980 | 45.9 |
| | | | N₂ (41.2) | | | |
| | | | H₂ (Remainder) | | | |
| Coating Film b | Intermediate Layer | CVD Method | TiCl₄ (2.0) | 6.7 | 915 | 63.8 |
| | | | N₂ (39.7) | | | |
| | | | H₂ (Remainder) | | | |
| | Surface Layer | CVD Method | TiCl₄ (0.5) | 79.8 | 980 | 45.9 |
| | | | N₂ (41.2) | | | |
| | | | H₂ (Remainder) | | | |
| Coating Film c | Intermediate Layer | CVD Method | TiCl₄ (2.0) | 6.7 | 915 | 63.8 |
| | | | N₂ (39.7) | | | |
| | | | H₂ (Remainder) | | | |
| | Surface Layer | CVD Method | TiCl₄ (0.5) | 79.8 | 980 | 45.9 |
| | | | N₂ (41.2) | | | |
| | | | H₂ (Remainder) | | | |

In the manner described above, the joined body in which substrate A was joined to the base body, and the cutting tool (sample No. 1) in which coating film a was provided on the surface of the substrate (the surface of the joined body) were produced.

### <Production of Sample No. 2>

A cutting tool of a sample No. 2 is different from the cutting tool of sample No. 1 in that instead of compound layer i, the cutting tool of sample No. 2 includes a coating film b having a compound layer (compound layer ii) constituted of a composition of Ti₁₋ₓAlₓC₁₋ₐNₐ (X=0.4 and a=0.9) as shown in Table 2. A method for producing the cutting tool of sample No. 2 is the same as the method for producing the cutting tool of sample No. 1 except for coating film b. Each layer of coating film b was produced under conditions shown in Table 3 and Table 4 using the CVD apparatus shown in Fig. 2.

In the manner described above, the joined body in which substrate A was joined to the base body, and the cutting tool (sample No. 2) in which coating film b was provided on the surface of the substrate (the surface of the joined body) were produced.

### <Production of Sample No. 3>

A cutting tool of a sample No. 3 is different from the cutting tool of sample No. 1 in that the cutting tool of sample No. 3 includes a coating film c having no compound layer. A method for producing the cutting tool of sample No. 3 is the same as the method for producing the cutting tool of sample No. 1 except for coating film c. Each layer of coating film c was produced under conditions shown in Table 3 and Table 4 using the CVD apparatus shown in Fig. 2.

### <<Cutting Test>>

Cutting performance of each of the cutting tools of samples No. 1 to No. 3 was evaluated in continuous cutting (high-load cutting) of a hardened steel.

Each of the cutting tools was used to perform a cutting process with a cutting distance of 3 km in accordance with the below-described cutting conditions. A result of a flank face wear amount (Vb) after the end of the cutting is shown in Table 5. As the value of Vb is smaller, the wear resistance is more excellent.

### (Cutting Conditions)

Workpiece: hardened steel SCM415H (HRC60); φ35 mm × 10 mm
Cutting speed: 180 m/min
Feed rate: 0.16 mm/rev
Depth of cut: 0.25 mm
Cutting oil: present (wet state).

**[Table 5]**

| Sample No. | Vb (mm) |
|---|---|
| 1 | 0.045 |
| 2 | 0.060 |
| 3 | 0.100 |

As shown in Table 5, it was confirmed that the cutting tool of sample No. 1 had high wear resistance even in the continuous cutting of the hardened steel. Therefore, the cutting tool of sample No. 1 ensures stable cutting even in high-load cutting.

### <Production of Sample No. 4>

A cutting tool of a sample No. 4 was produced in the following manner. This cutting tool is a cutting tool including the above-described substrate and a below-described compound layer (compound layer iii) constituted of a composition of Ti₁₋ₓAlₓC₁₋ₐNₐ (X=0.65 and a=0.95).

### <<Production of cBN Sintered Material B>>

A substrate B having a feature shown in Table 6 was produced in the following manner. First, TiN powder (average particle size of 3 µm) and Al powder (average particle size of 4 µm) were mixed at a mass ratio of 95:5 to prepare a mixture. Next, the mixture was heated for 30 minutes at 1250°C in vacuum. The mixture having been through the heating was pulverized using a cemented carbide ball with φ 4 mm and a cemented carbide pot, thereby obtaining raw material powder of the binder. Next, cBN powder constituted of cBN particles (average particle size of 4 µm) was prepared, and was mixed with the raw material powder of the binder such that a mixing ratio (volume %) of the raw material powder of the binder and the cBN powder became 25:75, thereby preparing a powder mixture.

This powder mixture was placed in a vacuum furnace, and was degassed by increasing the temperature to 950°C and then holding it for 30 minutes. Then, the degassed powder mixture was layered on a cemented carbide supporting plate, which was then introduced into a capsule composed of Mo. This capsule was placed in an ultra-high pressure apparatus and was sintered for 20 minutes at a pressure of 5 GPa and a temperature of 1300°C. In this way, substrate B was produced.

### <<Production of Joined Body>>

A base body was prepared which had a shape defined as DNGA150408 in the ISO standard and was composed of a cemented carbide material (corresponding to K10). The above-described substrate B (with a triangular prism shape that had a thickness of 2 mm and that had a bottom surface in the form of an isosceles triangle having a vertex angle of 55° and having 2-mm sides sandwiching the vertex angle) was joined to a cutting edge (corner portion) of the base body. It should be noted that a wax material composed of Ti-Zr-Cu was used for the joining. Next, the outer peripheral surface, upper surface, and lower surface of the joined body were ground to form a negative land shape (with a negative land width of 150 µm and a negative land angle of 25°) at the cutting edge. In this way, the joined body was produced in which the cutting edge portion was constituted of substrate B.

### <<Production of Coating Film d>>

On the surface of the produced joined body, a coating film d shown in Table 7 was formed. In Table 7, for example, the notation "Ti_{0.5}Al_{0.5}N (0.5)" means a Ti_{0.5}Al_{0.5}N layer having a thickness of 0.5 µm. Further, for example, the notation "compound layer iii (3)" means compound layer iii having a thickness of 3 µm and having a composition of Ti_{0.35}Al_{0.65}C_{0.05}N_{0.95} as shown in Table 8. In the production of coating film d, the intermediate layer was first produced by controlling the mixing ratio of the TiCl₄ gas and the AlCl₃ gas in the first gas, the flow rate ratio of the first gas and the second gas, the furnace pressure, and the furnace temperature in accordance with the same method as that in Table 3 using the CVD apparatus shown in Fig. 2 so as to obtain Ti_{0.5}Al_{0.5}N. The thickness of the intermediate layer was controlled by adjusting a time for introducing the first gas and the second gas into the reaction container. Then, compound layer iii on this intermediate layer was produced by performing adjustment in the same manner.

In Table 8, the notations "Bright Region" and "Dark Region" respectively refer to a relatively "bright region" and a relatively "dark region" in terms of brightness in a TEM image obtained by observing the coating film (compound layer) at a cross section obtained by the above-described method. The "bright region" and the "dark region" respectively correspond to portions with relatively high and low ratios of the Ti composition (Ti/(Al+Ti)). An area ratio of the bright region and the dark region in the compound layer as shown in Table 8 is based on a value identified from a TEM image of one visual field. The entire composition of the compound layer, and the ratios of the Al and Ti compositions in the bright region and the dark region are based on values measured in the above-described TEM image using the EDX included in the TEM. The crystal structure of the compound layer as shown in Table 8 was measured in the above-described TEM image using an electron diffractometer included in the TEM. In Table 8, an area ratio of the region with the NaCl type crystal structure in the compound layer was indicated as a NaCl type ratio.

**[Table 6]**

| | Content Ratio of cBN (vol%) | Grain Size of cBN Grains (µm) | Binder |
|---|---|---|---|
| Substrate B | 75 | 4 | AlN, TiN |

**[Table 7]**

| | Intermediate Layer | Compound Layer |
|---|---|---|
| Coating Film d | Ti_{0.5}Al_{0.5}N (0.5) | Compound Layer iii (3) |
| Coating Film e | Ti_{0.5}Al_{0.5}N (0.5) | Compound Layer iv (3) |
| Coating Film f | Ti_{0.5}Al_{0.5}N (0.5) | Compound Layer v (3) |
| Coating Film g | Ti_{0.5}Al_{0.5}N (0.5) | Compound Layer vi (3) |
| Coating Film h | Ti_{0.5}Al_{0.5}N (0.5) | Compound Layer vii (3) |
| Coating Film j | Ti_{0.5}Al_{0.5}N (0.5) | Compound Layer viii (3) |

**[Table 8]**

| | Entire Compound Layer | | | | | | Dark Region | | | | Bright Region | | | |
|---|---|---|---|---|---|---|---|---|---|---|---|---|---|---|
| | Entire Composition | | | | Crystal Structure | NaCl Type Ratio | Area Ratio | Composition Ratio of Ti and Al | | Crystal Structure | Area Ratio | Composition Ratio of Ti and Al | | Crystal Structure |
| | Ti | Al | C | N | | | | Ti | Al | | | Ti | Al | |
| Compound Layer iii | 0.35 | 0.65 | 0.05 | 0.95 | NaCl | 1.0 | 0.90 | 0.330 | 0.67 | NaCl | 0.10 | 0.530 | 0.47 | NaCl |
| Compound Layer iv | 0.23 | 0.77 | 0.05 | 0.95 | NaCl | 1.0 | 0.80 | 0.190 | 0.81 | NaCl | 0.20 | 0.390 | 0.61 | NaCl |
| Compound Layer v | 0.17 | 0.83 | 0.05 | 0.95 | NaCl | 1.0 | 0.75 | 0.130 | 0.87 | NaCl | 0.25 | 0.300 | 0.7 | NaCl |
| Compound Layer vi | 0.13 | 0.87 | 0.05 | 0.95 | NaCl | 1.0 | 0.58 | 0.080 | 0.92 | NaCl | 0.42 | 0.200 | 0.8 | NaCl |
| Compound Layer vii | 0.07 | 0.93 | 0.05 | 0.95 | NaCl+Wurtzite | 0.6 | 0.40 | 0.020 | 0.98 | Wurtzite | 0.60 | 0.100 | 0.9 | NaCl |
| Compound Layer viii | 0.03 | 0.97 | 0.05 | 0.95 | Wurtzite | 0.0 | 0.25 | 0.000 | 1.00 | Wurtzite | 0.75 | 0.040 | 0.96 | Wurtzite |

In the manner described above, the joined body in which substrate B was joined to the base body, and the cutting tool (sample No. 4) in which coating film d was provided on the surface of the substrate (the surface of the joined body) were produced.

### <Production of Sample No. 5>

A cutting tool of a sample No. 5 is different from the cutting tool of sample No. 4 in that instead of the above-described compound layer (compound layer iii), the cutting tool of sample No. 5 includes a coating film e having a compound layer (compound layer iv) constituted of a composition of Ti₁₋ₓAlₓC₁₋ₐNₐ (X=0.77 and a=0.95) as shown in Table 8. A method for producing the cutting tool of sample No. 5 is the same as the method for producing the cutting tool of sample No. 4 except for coating film e. Regarding each layer of coating film e, the intermediate layer was produced in the same manner as sample No. 4, and compound layer iv was produced using the CVD apparatus shown in Fig. 2 by controlling the mixing ratio of the TiCl₄ gas and the AlCl₃ gas in the first gas, the flow rate ratio of the first gas and the second gas, the furnace pressure, and the furnace temperature so as to attain a composition shown in Table 8. The thickness of compound layer iv was controlled by adjusting a time for introducing the first gas and the second gas into the reaction container.

In the manner described above, the joined body in which substrate B was joined to the base body, and the cutting tool (sample No. 5) in which coating film e was provided on the surface of the substrate (the surface of the joined body) were produced.

### <Production of Sample No. 6>

A cutting tool of a sample No. 6 is different from the cutting tool of sample No. 4 in that instead of the above-described compound layer (compound layer iii), the cutting tool of sample No. 6 includes a coating film f having a compound layer (compound layer v) constituted of a composition of Ti₁₋ₓAlₓC₁₋ₐNₐ (X=0.83 and a=0.95) as shown in Table 8. A method for producing the cutting tool of sample No. 6 is the same as the method for producing the cutting tool of sample No. 4 except for coating film f. Regarding each layer of coating film f, the intermediate layer was produced in the same manner as sample No. 4, and compound layer v was produced using the CVD apparatus shown in Fig. 2 by controlling the mixing ratio of the TiCl₄ gas and the AlCl₃ gas in the first gas, the flow rate ratio of the first gas and the second gas, the furnace pressure, and the furnace temperature so as to attain a composition shown in Table 8. The thickness of compound layer v was controlled by adjusting a time for introducing the first gas and the second gas into the reaction container.

In the manner described above, the joined body in which substrate B was joined to the base body, and the cutting tool (sample No. 6) in which coating film f was provided on the surface of the substrate (the surface of the joined body) were produced.

### <Production of Sample No. 7>

A cutting tool of a sample No. 7 is different from the cutting tool of sample No. 4 in that instead of the above-described compound layer (compound layer iii), the cutting tool of sample No. 7 includes a coating film g having a compound layer (compound layer vi) constituted of a composition of Ti₁₋ₓAlₓC₁₋ₐNₐ (X=0.87 and a=0.95) as shown in Table 8. A method for producing the cutting tool of sample No. 7 is the same as the method for producing the cutting tool of sample No. 4 except for coating film g. Regarding each layer of coating film g, the intermediate layer was produced in the same manner as sample No. 4, and compound layer vi was produced using the CVD apparatus shown in Fig. 2 by controlling the mixing ratio of the TiCl₄ gas and the AlCl₃ gas in the first gas, the flow rate ratio of the first gas and the second gas, the furnace pressure, and the furnace temperature so as to attain a composition shown in Table 8. The thickness of compound layer vi was controlled by adjusting a time for introducing the first gas and the second gas into the reaction container.

In the manner described above, the joined body in which substrate B was joined to the base body, and the cutting tool (sample No. 7) in which coating film g was provided on the surface of the substrate (the surface of the joined body) were produced.

### <Production of Sample No. 8>

A cutting tool of a sample No. 8 is different from the cutting tool of sample No. 4 in that instead of the above-described compound layer (compound layer iii), the cutting tool of sample No. 8 includes a coating film h having a compound layer (compound layer vii) constituted of a composition of Ti₁₋ₓAlₓC₁₋ₐNₐ (X=0.93 and a=0.95) as shown in Table 8. A method for producing the cutting tool of sample No. 8 is the same as the method for producing the cutting tool of sample No. 4 except for coating film h. Regarding each layer of coating film h, the intermediate layer was produced in the same manner as sample No. 4, and compound layer vii was produced using the CVD apparatus shown in Fig. 2 by controlling the mixing ratio of the TiCl₄ gas and the AlCl₃ gas in the first gas, the flow rate ratio of the first gas and the second gas, the furnace pressure, and the furnace temperature so as to attain a composition shown in Table 8. The thickness of compound layer vii was controlled by adjusting a time for introducing the first gas and the second gas into the reaction container.

In the manner described above, the joined body in which substrate B was joined to the base body, and the cutting tool (sample No. 8) in which coating film h was provided on the surface of the substrate (the surface of the joined body) were produced.

### <Production of Sample No. 9>

A cutting tool of a sample No. 9 is different from the cutting tool of sample No. 4 in that instead of the above-described compound layer (compound layer iii), the cutting tool of sample No. 9 includes a coating film j having a compound layer (compound layer viii) constituted of a composition of Ti₁₋ₓAlₓC₁₋ₐNₐ (X=0.97 and a=0.95) as shown in Table 8. A method for producing the cutting tool of sample No. 9 is the same as the method for producing the cutting tool of sample No. 4 except for coating film j. Regarding each layer of coating film j, the intermediate layer was produced in the same manner as sample No. 4, and compound layer viii was produced using the CVD apparatus shown in Fig. 2 by controlling the mixing ratio of the TiCl₄ gas and the AlCl₃ gas in the first gas, the flow rate ratio of the first gas and the second gas, the furnace pressure, and the furnace temperature so as to attain a composition shown in Table 8. The thickness of compound layer viii was controlled by adjusting a time for introducing the first gas and the second gas into the reaction container.

In the manner described above, the joined body in which substrate B was joined to the base body, and the cutting tool (sample No. 9) in which coating film j was provided on the surface of the substrate (the surface of the joined body) were produced.

### <<Cutting Test>>

Cutting performance of each of the cutting tools of samples No. 4 to No. 9 was evaluated in a cutting process (intermittent process) of a bearing steel.

Each cutting tool was used to perform a cutting process in a length of 30 mm for each workpiece under below-described cutting conditions, and a flank face wear amount (Vb) after performing the cutting process to 200 workpieces was measured. Results thereof are shown in Table 9. As the value of Vb is smaller, the wear resistance is more excellent.

### (Cutting Conditions)

Workpiece: bearing steel SUJ2 (HRC60); φ50 mm × 45 mm
Cutting speed: 150 m/min
Feed rate: 0.2 mm/rev
Depth of cut: 0.1 mm
Cutting oil: none

**[Table 9]**

| Sample No. | Vb (mm) |
|---|---|
| 4 | 0.20 |
| 5 | 0.14 |
| 6 | 0.12 |
| 7 | 0.09 |
| 8 | 0.11 |
| 9 | 0.22 |

As shown in Table 9, it was confirmed that each of the cutting tools of samples No. 5 to No. 8 had high wear resistance even in the cutting process (intermittent process) of the bearing steel. Therefore, each of the cutting tools of samples No. 5 to No. 8 ensures stable cutting even in high-load cutting.

The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

### REFERENCE SIGNS LIST

1: substrate; 2: coating film; 3: compound layer; 4: intermediate layer; 5: surface layer; 10: cutting tool; 11: substrate holding jig; 12: reaction container; 13: temperature adjusting apparatus; 14: gas inlet pipe; 15: gas inlet pipe; 16: axis; 17: gas outlet pipe; 18: gas outlet; 20: CVD apparatus.

## Claims

1. A cutting tool comprising a substrate and a coating film provided on the substrate, wherein
the substrate is a cubic boron nitride sintered material including more than or equal to 30 volume % and less than 80 volume % of cubic boron nitride and a binder,
the coating film includes a compound layer constituted of a composition of Ti₁₋ₓAlₓC₁₋ₐNₐ, where 0.70≤X≤0.95 and 0<a≤1, and
the compound layer has a NaCl type crystal structure in a whole or part of the compound layer.

2. The cutting tool according to claim 1, wherein the binder includes at least one of Al and an Al compound, the Al compound being composed of Al and one or more elements selected from C, N, O, and B.

3. The cutting tool according to claim 1 or claim 2, wherein the compound layer further has a wurtzite type crystal structure.

4. The cutting tool according to any one of claim 1 to claim 3, wherein a ratio of the NaCl type crystal structure in the compound layer is more than or equal to 50 volume %.

5. A method for manufacturing a cutting tool, the method comprising:
producing a substrate composed of a cubic boron nitride sintered material including more than or equal to 30 volume % and less than 80 volume % of cubic boron nitride and a binder; and
forming a coating film on a surface of the substrate, wherein
the forming of the coating film includes forming a compound layer by a CVD method, the compound layer being constituted of a composition of Ti₁₋ₓAlₓC₁₋ₐNₐ, where 0.70≤X≤0.95 and 0<a≤1, the compound layer having a NaCl type crystal structure in a whole or part of the compound layer.
